# FASCICULE DE BREVET EUROPEEN

(11) **EP 0 425 326 B1**
(45) Date de publication et mention de la délivrance du brevet: **16.06.1993**
(21) Numéro de dépôt: 90402671.3
(22) Date de dépôt: 27.09.1990
(51) Int. Cl.: H05K 7/20

(54) **Module de fixation et d'amortissement d'un ventilateur**
Befestigungs- und Dämpfungsmodul für einen Ventilator
Holding and damping module for a fan

(30) Priorité: 05.10.1989 FR 8913036
(43) Date de publication de la demande: 02.05.1991
(73) Titulaire: BULL S.A., 92800 Puteaux (FR)
(72) Inventeur: Remise, René, F-91940 Les Ulis (FR); Jardet, Gilles, F-91380 Chilly Mazarin (FR)
(74) Mandataire: Debay, Yves

(56) Documents cités:
- EP-A- 0 135 845
- DE-A- 3 408 139
- DE-U- 8 707 975
- US-A- 4 517 880

## Description

La présente invention concerne un module de fixation et d'amortissement d'un ventilateur pour châssis de machine électronique.

La plupart du temps le ventilateur, destiné à effectuer le refroidissement des composants électroniques placés dans le châssis d'une machine, est fixé par des moyens démontables, tels que des vis sur ce châssis et nécessite, pour sa mise en place, une opération d'assemblage relativement longue et des manipulations qui, finalement, sont coûteuses. De plus, lorsque l'on veut obtenir un ventilateur ayant un bruit de fonctionnement le plus faible possible, il est nécessaire d'utiliser des moyens de fixation tendant à réduire ces bruits. La plupart du temps, il s'agit d'un bloc élastique monté sur la vis de fixation entre le boîtier du ventilateur et le châssis de la machine. L'assemblage d'un tel dispositif nécessite d'abord l'introduction de la vis dans le boîtier du ventilateur, ensuite la mise en place de la pièce élastique et la fixation de l'ensemble sur le châssis. Ces opérations sont délicates, et difficilement automatisables, et viennent grèver le coût du produit.

Le but de l'invention est donc de proposer un module de fixation et d'amortissement d'un ventilateur qui permette d'assurer la fixation et la réduction des bruits de fonctionnement du ventilateur, tout en ayant un assemblage facile et rapide.

Ce but est atteint par le fait que le module de fixation set d'amortissement du ventilateur pour châssis de machine électronique comporte un boîtier support (1) en forme de parallélépipède à angles coupés pourvu sur ses faces supérieure et inférieure d'ouvertures de circulation d'air, ladite face supérieure comportant des moyens d'accrochage sur le châssis de la machine, lesdits angles coupés comportant des ouvertures permettant l'introduction des angles d'un ensemble formé par le bloc ventilateur, entouré sur sa périphérie d'un bloc de mousse.

Selon un mode de réalisation, les ouvertures sont trapézoïdales avec la petite base du trapèze proche de l'ouverture de la face supérieure.

Selon un autre mode de réalisation, l'ouverture de la face supérieure est de dimensions supérieures au boîtier du bloc ventilateur, mais inférieures aux dimensions de l'ensemble ventilateur / bloc de mousse.

Selon un autre mode de réalisation, le boîtier ventilateur comporte des flancs latéraux reliés par une portion cylindrique, de façon à former une gorge circulaire et des bossages régulièrement répartis, de préférence à l'emplacement des flancs.

Selon une autre caractéristique, le boîtier comporte sur ses flancs internes des bossages de calage de l'ensemble ventilateur / bloc de mousse.

Selon un autre mode de réalisation, le bloc ventilateur est solidaire par un câble électrique d'un circuit imprimé comportant une plage de connexion, ledit circuit imprimé étant introduit en premier dans une ouverture avant l'ensemble ventilateur / bloc de mousse, pour venir se fixer sur la face inférieure, à l'arrière du boîtier sur des tétons de fixation élastiques.

Selon un dernièr mode de réalisation, la face avant comporte des crochets constituant des moyens d'accrochage sur le châssis, la dimension et la position du circuit étant conçues pour que la plage de connexion vienne en vis-à-vis d'un connecteur monté sur la carte principale de la machine.

D'autres caractéristiques et avantages de la présente invention apparaîtront plus clairement à la lecture de la description ci-après, faite en référence aux dessins annexés, dans lesquels :
- la figure 1 représente une vue en perspective du module de fixation et d'amortissement selon un mode de réalisation préféré de l'invention ;
- la figure 2 représente une vue en perspective du châssis de la machine sur lequel le module est monté ;
- la figure 3 représente une vue de l'arrière du module de fixation ;
- la figure 4 représente une vue de côté du module de fixation.

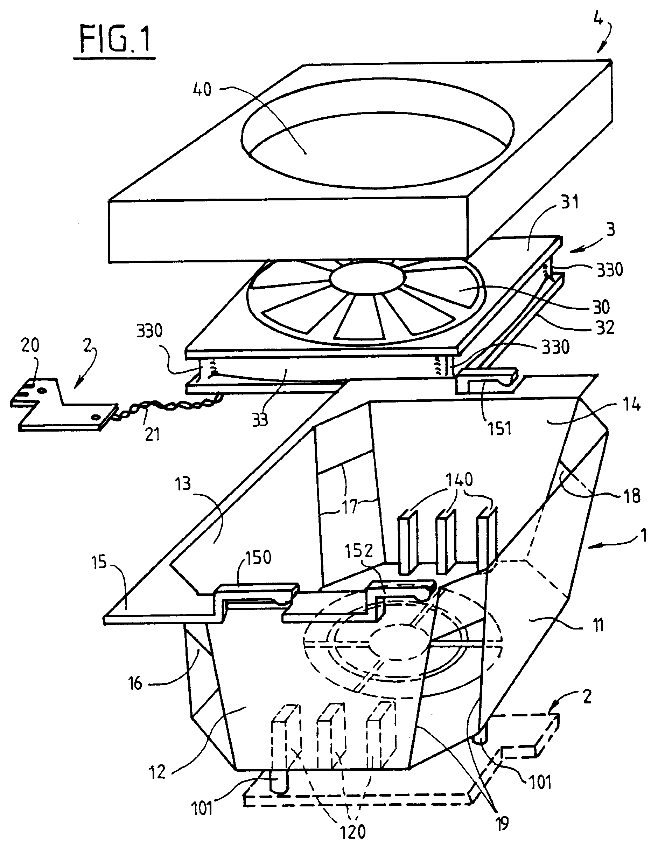

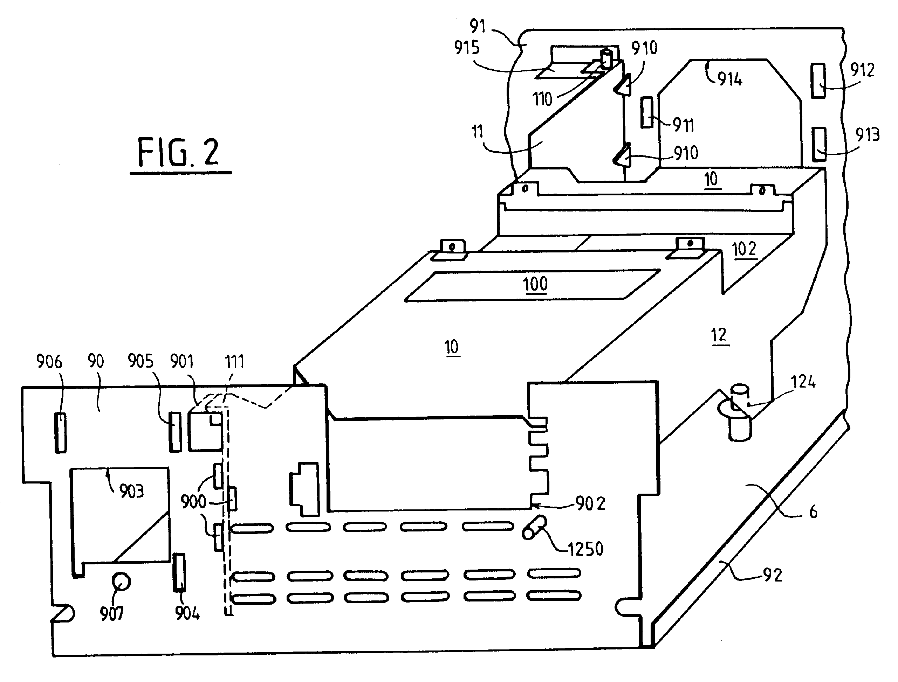

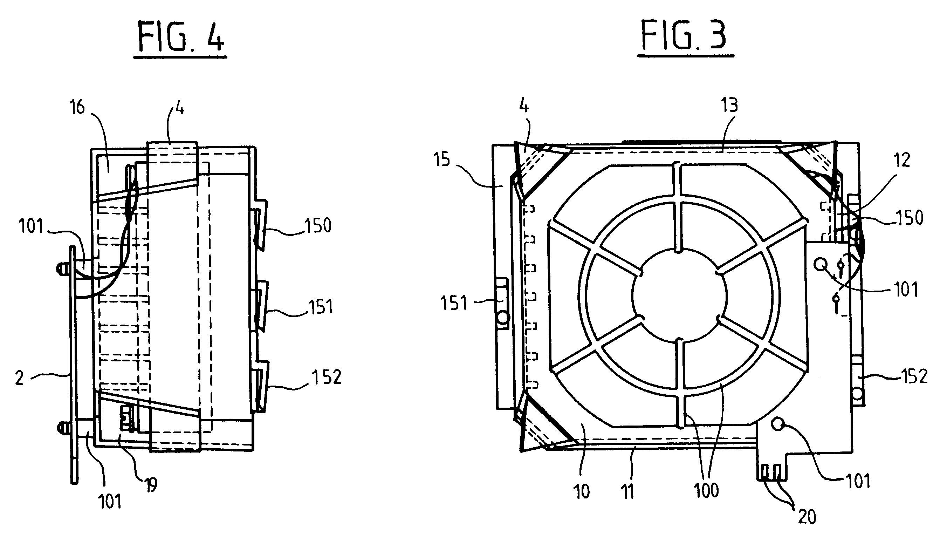

L'invention sera expliquée à l'aide des figures 1,2, 3 et 4, sur lesquelles on peut voir que le module est constitué d'un boîtier (1) en forme de parallélépipède à angles coupés, et dont les faces parallèles (11, 13, 12, 14) sont reliées entre elles par des portions de surfaces trapézoïdales pourvues d'ouvertures trapézoïdales (16, 17, 18, 19). Les ouvertures trapézoïdales ont leur petite base orientée vers la face supérieure du boîtier et située à une distance de la face supérieure du boîtier telle que l'espace séparant cette base supérieure des bossages (120, 140) décrits ci-après corresponde substantiellement à l'épaisseur du boîtier ventilateur ou du bloc de mousse. La face supérieure (15) du boîtier comporte des crochets (150, 151, 152) d'accrochage de l'ensemble boîtier sur le châssis d'une machine. La face inférieure (10), ou fond du boîtier, est pourvue, comme on peut le voir sur la figure 3, d'ouvertures délimitées par des nervures (100). Les faces supérieure et inférieure (15, 10) sont conçues de façon à permettre une circulation aisée du flux d'air, parallèlement aux faces latérales (11, 12, 13, 14). Les faces latérales (11, 12, 13, 14) peuvent avoir une légère dépouille vers la face inférieure (10) de façon à permettre un démoulage plus aisé de la pièce lors de sa fabrication. Certaines faces latérales (12, 14) comportent sur leur surface interne des bossages (120, 140). De même, la face inférieure (10) comporte sur sa surface orientée vers l'extérieur deux tétons (101) permettant la fixation d'un circuit imprimé (2), comme on le verra par la suite. Ce boîtier (1) est utilisé pour mettre en place à l'intérieur un boîtier de ventilateur (3), comportant un ventilateur (30), entouré par deux flancs latéraux (31, 32), dont les surfaces sont disposées perpendiculairement à l'axe de rotation du ventilateur, ces deux surfaces (31, 32) étant reliées entre elles par une portion cylindrique (33) de façon à former une gorge présentant des bossages (330), régulièrement répartis à sa périphérie. Le moteur du ventilateur est relié par un câble (21) à un circuit imprimé (2), qui comporte à une de ses extrémités une plage de connexion (20). Dans la gorge du boîtier du ventilateur, on vient monter un bloc de mousse (4), dont la partie centrale (40) a été vidée de façon à venir s'adapter sur la périphérie de la portion cylindrique (33). Les bossages (330), pénétrant dans le bloc de mousse, permettent d'assurer une solidarisation en rotation de ce bloc de mousse par rapport aux angles du boîtier du ventilateur. Le montage de l'ensemble bloc de mousse (4), ventilateur (3) s'effectue en glissant premièrement le circuit imprimé (2) à travers l'ouverture (16), en le faisant passer de l'intérieur du boîtier (1) vers l'extérieur de celui-ci. Ensuite, le bloc de mousse est introduit dans l'ouverture (16) en inclinant l'ensemble bloc de mousse / ventilateur, puis par compression du bloc de mousse entre le ventilateur et le boîtier (1), on provoque le basculement de l'ensemble boîtier ventilateur / bloc de mousse, pour faire pénétrer successivement chacun des angles du bloc de mous se dans les ouvertures respectives (17, 18, 19). Les bossages (140, 120) permettent d'éviter que le bloc de mousse ait tendance à descendre vers le fond du boîtier (1). Les ouvertures (16, 17, 18, 19), ayant une forme trapézoïdale dont la dimension se réduit vers la face supérieure du boîtier, permettent d'assurer un coincement du bloc de mousse (4) contribuant ainsi à la fixation de l'ensemble ventilateur (3) / bloc de mousse.

Pour terminer l'opération de montage, le circuit imprimé (2) est monté sur les tétons (101) de la façon représentée en pointillés sur la figure 1. Une fois l'assemblage du module effectué, celui-ci est amemé en vis-à-vis de l'ouverture (914) de la face arrrière (91) du châssis de la machine, et les ergots d'accrochage (150, 151, 152) pénètrent dans les ouvertures (911, 912, 913) découpées dans la face arrière (91) et assurent ainsi la fixation du module. Cette fixation du module est complétée également par le fait que la plage de connexion (20) du circuit imprimé pénètre dans un connecteur non représenté, monté dans la position adéquate sur la carte principale (6) de la machine.

## Revendications

1. Module de fixation et d'amortissement d'un ventilateur pour châssis de machine électronique, caractérisé en ce qu'il comporte un boîtier support (1) en forme de parallélépipède à angles coupés, pourvu sur ses faces supérieures (15) et inférieure (10) d'ouvertures de circulation d'air, ladite face supérieure (15) comportant des moyens d'accrochage (150, 151, 152) sur le châssis (91) de la machine, lesdits angles coupés comportant des ouvertures (16, 17, 18, 19) permettant l'introduction des angles d'un ensemble formé par le bloc ventilateur (3) entouré sur sa périphérie d'un bloc de mousse (4).

2. Module selon la revendication 1, caractérisé en ce que les ouvertures (16, 17, 18, 19) sont trapézoïdales avec la petite base du trapèze proche de l'ouverture de la face supérieure (15).

3. Module selon la revendication 1 ou 2, caractérisé en ce que l'ouverture de la face supérieure (15) est de dimension supérieure au boîtier du bloc ventilateur, mais inférieure aux dimensions de l'ensemble ventilateur (3), bloc de mousse (4).

4. Module selon la revendication 3, caractérisé en ce que le boîtier ventilateur (3) comporte des flancs latéraux (31, 32) reliés par une portion cylindrique (33) de façon à former une gorge circulaire et des bossages (330) régulièrement répartis, de préférence à l'emplacement des angles des flancs (31, 32).

5. Module selon la revendication 3 ou 4, caractérisé en ce que le boîtier (1) comporte sur ses flancs internes (14, 12) des bossages (120, 140) de calage de l'ensemble ventilateur (3), bloc de mousse (4).

6. Module selon la revendication 4 ou 5, caractérisé en ce que le bloc ventilateur (3) est solidaire par un câble électrique (21) d'un circuit imprimé (2) comportant une plage de connexion (20), ledit circuit imprimé étant introduit dans une ouverture (16) avant l'ensemble bloc ventilateur pour venir se fixer sur la face inférieure (10), à l'arrière du boîtier (1) sur des tétons (101) de fixation élastique.

7. Module selon la revendication 6, caractérisé en ce que la face avant (15) comporte des crochets (150, 151, 152) constituant les moyens d'accrochage sur le châssis (91), la dimension et la position du circuit (2) étant conçues pour que la plage de connexion vienne en vis-à-vis d'un connecteur monté sur la carte principale (6) de la machine.

## Patentansprüche

1. Befestigungs- und Dämpfungsmodul eines Ventilators für ein Chassis einer elektronischen Maschine, dadurch gekennzeichnet, daß er ein Trägergehäuse (1) in der Form eines Parallelepipeds mit geschnittenen Kanten aufweist, das an seiner oberen (15) und unteren Seite (10) mit Luftzirkulationsöffnungen versehen ist, wobei die obere Seite (15) Befestigungsmittel (150, 151, 152) zur Befestigung an dem Chassis (91) der Maschine aufweist und die geschnittenen Kanten Öffnungen (16, 17, 18, 19) enthalten, die die Einführung von Kanten einer Einheit gestatten, die durch den Ventilatorblock (3) gebildet ist, der an seinem Umfang von einem Schaumstoffblock (4) umgeben ist.

2. Modul nach Anspruch 1, dadurch gekennzeichnet, daß die Öffnungen (16, 17, 18, 19) trapezförmig sind und die kleine Trapezbasis jeweils nahe der Öffnung der oberen Seite (15) ist.

3. Modul nach Anspruch 1 oder 2, dadurch gekennzeichnet, daß die Öffnung der oberen Seite (15) größer als das Gehäuse des Ventilatorblockes, jedoch kleiner als die Abmessungen der Einheit Ventilator (3), Schaumstoffblock (4) bemessen ist.

4. Modul nach Anspruch 3, dadurch gekennzeichnet, daß das Ventilatorgehäuse (3) Seitenteile (31, 32) enthält, die durch einen Zylinderabschnitt (33) verbunden sind, so daß eine kreisförmige Einschnürung und gleichmäßig verteilte Vorsprünge (330) vorzugsweise an der Stelle der Kanten der Seitenteile (31, 32) gebildet werden.

5. Modul nach Anspruch 3 oder 4, dadurch gekennzeichnet, daß das Gehäuse (1) an seinen Innenseiten (14, 12) Vorsprünge (120, 140) zur Verkeilung der Einheit Ventilator (3), Schaumstoffblock (4) aufweist.

6. Modul nach Anspruch 4 oder 5, dadurch gekennzeichnet, daß der Ventilatorblock (3) durch ein elektrisches Kabel (21) fest mit einer gedruckten Schaltung (2) verbunden ist, die einen Anschlußbereich (20) besitzt, wobei die gedruckte Schaltung vor der Ventilatorblock-Einheit in eine Öffnung (16) eingeführt wird, um an der unteren Seite (10) an der Rückseite des Gehäuses (1) an Ansätzen (101) für eine elastische Befestigung festgelegt zu werden.

7. Modul nach Anspruch 6, dadurch gekennzeichnet, daß die Vorderseite (15) Haken (150, 151, 152) aufweist, die die Befestigungsmittel zur Befestigung an dem Chassis (91) bilden, wobei die Abmessungen und die Lage der Schaltung (2) so gewählt sind, daß der Anschlußbereich schließlich einem Verbinder gegenüberliegt, der auf der Hauptkarte (6) der Maschine montiert ist.

## Claims

1. A module for fixing and damping a fan for the frame of an electronic machine, characterised in that it comprises a support housing (1) in the form of a parallelepiped with cut-off corners, provided on its upper (15) and lower (10) faces with openings for air circulation, said upper face (15) comprising means (150, 151, 152) for hooking to the frame (91) of the machine, said cut-off corners comprising openings (16, 17, 18, 19) allowing the insertion of the corners of an assembly formed by the fan unit (3) surrounded on its periphery by a block of foam (4).

2. A module according to Claim 1, characterised in that the openings (16, 17, 18, 19) are trapezoidal with the small base of the trapezium close to the opening of the upper face (15).

3. A module according to Claim 1 or 2, characterised in that the opening of the upper face (15) is greater in size than the housing of the fan unit, but smaller than the dimensions of the fan (3)/foam block (4) assembly.

4. A module according to Claim 3, characterised in that the fan housing (3) comprises lateral side walls (31, 32) connected by a cylindrical portion (33) so as to form a circular groove and regularly distributed bosses (330), preferably in the position of the corners of the side walls (31, 32).

5. A module according to Claim 3 or 4, characterised in that the housing (1) comprises on its inner side walls (14, 12) bosses (120, 140) for wedging the fan (3)/foam block (4) assembly.

6. A module according to Claim 4 or 5, characterised in that the fan unit (3) is made integral by an elactric cable (21) with a printed circuit (2) comprising a connection region (20), said printed circuit being inserted into an opening (16) before the fan unit assembly so as to be fastened to the lower face (10), at the back of the housing (1), on resilient fastening studs (101).

7. A module according to Claim 6, characterised in that the front face (15) comprises hooks (150, 151, 152) constituting the means for hooking to the frame (91), the dimension and position of the circuit (2) being designed so that the connection region faces a connector mounted on the main board (6) of the machine.
